Europäisches Patentamt

European Patent Office

Office européen des brevets

(11) Veröffentlichungsnummer: **0 394 859**
**A1**

## (12) EUROPÄISCHE PATENTANMELDUNG

(21) Anmeldenummer: 90107502.8

(22) Anmeldetag: 20.04.90

(51) Int. Cl.5: **H01L 29/747**

(30) Priorität: 28.04.89 CH 1636/89

(43) Veröffentlichungstag der Anmeldung:
**31.10.90 Patentblatt 90/44**

(84) Benannte Vertragsstaaten:
**CH DE IT LI SE**

(71) Anmelder: **ASEA BROWN BOVERI AG**
**Haselstrasse**
**CH-5401 Baden(CH)**

(72) Erfinder: **Bauer, Friedhelm, Dr.**
**Breitenstrasse 9**
**CH-5303 Würenlingen(CH)**
Erfinder: **Stockmeier, Thomas**
**Erbsackerweg 1048**
**CH-5303 Würenlingen(CH)**

(54) **Bidirektionals, abschaltbares Halbeiterbauelement.**

(57) Bei einem symmetrisch aufgebauten TRIAC, der ein Halbleitersubstrat (20) mit einer innenliegenden n-Basisschicht (9), zwei angrenzenden p-Basisschichten (7, 11), zwei in die p-Basisschichten (7, 11) eingelassenen n-Emittergebieten (4, 12), zwei auf den Hauptflächen (29, 30) angeordneten Hauptelektroden (1, 17) und zwei Zündvorrichtungen umfasst, wird eine vereinfachte Steuerung durch MOS-kontrollierte Kurzschlüsse (3, 5, 6, 7 bzw. 11, 13, 14, 16) an den n-Emittergebieten (4 bzw. 12) erreicht.

FIG.1

EP 0 394 859 A1

## BIDIREKTIONALES, ABSCHALTBARES HALBLEITERBAUELEMENT

### TECHNISCHES GEBIET

Die vorliegende Erfindung bezieht sich auf das Gebiet der Leistungselektronik. Sie betrifft insbesondere ein bidirektionales, abschaltbares Halbleiterbauelement, umfassend

(a) ein Halbleitersubstrat, welches durch zwei Hauptflächen begrenzt wird und zwischen den Hauptflächen eine Mehrzahl unterschiedlich dotierter Schichten aufweist;

(b) auf der ersten Hauptfläche eine erste, zu einem ersten Hauptanschluss gehörende Hauptelektrode;

(c) auf der zweiten Hauptfläche eine zweite, zu einem zweiten Hauptanschluss gehörende Hauptelektrode;

(d) im Inneren des Halbleitersubstrats eine erste Basisschicht;

(e) unter der ersten Hauptelektrode eine Anzahl von ersten Emittergebieten, welche von der ersten Hauptfläche in das Halbleitersubstrat hineinragen und von der ersten Hauptelektrode kontaktiert werden;

(f) unter der zweiten Hauptelektrode eine Anzahl von zweiten Emittergebieten, welche von der zweiten Hauptfläche in das Halbleitersubstrat hineinragen und von der zweiten Hauptelektrode kontaktiert werden;

(g) erste, durch MOSFETs kontrollierte Kurzschlüsse, welche die ersten Emittergebiete kurzschliessen; und

(h) zweite, durch MOSFETs kontrollierte Kurzschlüsse, welche die zweiten Emittergebiete kurzschliessen.

Ein solches Bauelement ist z.B. aus der EP-B1-0 111 804 bekannt.

### STAND DER TECHNIK

Moderne Leistungshalbleiterbauelemente müssen eine Reihe von Anforderungen erfüllen, um über die Standardisierung von Umrichterkomponenten eine Veringerung des Entwurfsaufwandes und der Produktionskosten von industriellen Antrieben zu ermöglichen (siehe dazu: T. A. Lipo, IEEE Trans. Power Electronics, Vol.3, No.2 (1988), S.105-117).

Hierfür ist eine Vereinfachung der Ansteuerung von abschaltbaren Leistungshalbleitern (z.B. dem GTO), wie man sie bei den MOS-Leistungstransistoren im Bereich kleiner Leistungen gewohnt ist, eine ganz wesentliche Voraussetzung. Andererseits kann auf die bipolare Natur des Schalters nicht verzichtet werden, da nur so die Durchlassverluste bei Bauelementen für höhere Spannungen ($\Delta$ 1kV) in einem vertretbaren Rahmen bleiben.

Zur Lösung dieses Problems werden seit längerer Zeit Leistungshalbleiter entwickelt, welche bipolare Leitungsmechanismen mit einer MOS-Ansteuerung kombinieren. Der Insulated Gate Bipolar Transistor (IGBT), der z.B. von B. J. Baliga et al., IEEE Int. Electron Dev. Meet. Techn. Dig. (1982), S.264-267 unter der Bezeichnung IGR (Isolated Gate Rectifier) beschrieben worden ist, ist ein bereits kommerziell erhältlicher Vertreter dieser neuen Klasse von BIMOS(BIpolar MOS)-Bauelementen.

Der IGBT (IGR) ist ebenso einfach anzusteuern wie ein Leistungs-MOSFET, diesem aber in Bezug auf den ON-Widerstand für Spannungen grösser 500 V deutlich überlegen.

Beim IGBT wird der Basisstrom einer Bipolarstruktur über einen integrierten MOSFET gesteuert. Damit ist die Modulation des Widerstands der Basis begrenzt möglich. Daraus folgt, dass die maximal möglichen Sperrspannungen für IGBTs derzeit bei 1000 V oder geringfügig darüber liegen. Höhere Sperrspannungen sind bisher wegen des grossen ON-Widerstandes nicht ohne weiteres realisierbar.

Für höhere Spannungen bietet sich andererseits eine Thyristorstruktur an, bei der Kathodenkurzschlüsse über MOS-Gates geschaltet werden können. Derartige MOS-kontrollierte Thyristoren (MOS Controlled Thyristors = MCT) werden beispielsweise in dem Artikel von V. A. K. Temple, IEEE Trans. Electron Dev., ED-33 (1986), S.1609-1618, beschrieben.

Der MCT lässt sich so auslegen, dass er über ein einziges MOS-Gate ein- und ausgeschaltet werden kann (durch Ansteuerung mit einem positiven bzw. negativen Potential). Andererseits besitzt dieses Bauelement eine asymmetrische Struktur, so dass es Strom nur in einer Richtung leiten oder sperren kann.

Für die Realisierung moderner Umrichterkonzepte (z.B. der in dem Artikel von T. A. Lipo erwähnten Matrixkonverter) ist es aber eine wesentliche Voraussetzung, über ein Bauelement mit der Fähigkeit zu bidirektionaler Leit- und Sperrfähigkeit zu verfügen.

Ein bidirektionaler IGR ist bereits in der eingangs genannten EP-B1-0 111 804 ausführlich beschrieben worden. Als IGR unterliegt dieses bekannte bidirektionale Bauelement aber den gleichen Einschränkungen hinsichtlich der Sperrspannung wie der oben erwähnte unidirektionale IGR.

## DARSTELLUNG DER ERFINDUNG

Aufgabe der vorliegenden Erfindung ist es daher, ein bidirektionales, abschaltbares Halbleiterbauelement zu schaffen, welches einerseits mit einfachen Mitteln ansteuerbar ist und andererseits für deutlich höhere Sperrspannungen ausgelegt werden kann.

Die Aufgabe wird bei einem Bauelement der eingangs genannten Art dadurch gelöst, dass

(i) die ersten und zweiten Emittergebiete eine Dotierung mit derselben Polarität aufweisen wie die erste Basisschicht;

(k) zwischen der ersten Basisschicht und den ersten Emittergebieten eine mit entgegengesetzter Polarität dotierte zweite Basisschicht angeordnet ist, in welche die ersten Emittergebiete hineinragen;

(l) zwischen der ersten Basisschicht und den zweiten Emittergebieten eine mit entgegengesetzter Polarität dotierte dritte Basisschicht angeordnet ist, in welche die zweiten Emittergebiete hineinragen;

(m) die zweite und dritte Basisschicht lateral begrenzt ist, derart, dass die erste Basisschicht im Bereich der zweiten Basisschicht an die zweite Hauptfläche und im Bereich der dritten Basisschicht an die erste Hauptfläche tritt; und

(n) gegenüber der zweiten und dritten Basisschicht jeweils weitere Emitter zwischen der ersten Basisschicht und der zugehörigen Hauptelektrode angeordnet sind, welche mit derselben Polarität dotiert sind wie die zweite und dritte Basisschicht.

Ein erstes bevorzugtes Ausführungsbeispiel zeichnet sich dadurch aus, dass

(a) die erste Basisschicht eine n-dotierte n-Basisschicht ist;

(b) die ersten und zweiten Emittergebiete jeweils $n^+$-dotierte n-Emittergebiete sind; und

(c) die zweite und dritte Basisschicht jeweils p-dotierte p-Basisschichten sind.

Ausgehend von dem ansich bekannten Konzept eines TRIAC werden also die n-Emitter auf beiden Seiten des Bauelements mit durch MOSFETs ein- und ausschaltbaren Emitterkurzschlüssen ausgestattet. Ein Einschalten dieser Kurzschlüsse führt zur Unterbrechung der Elektronenemission und damit zum Abschalten der entsprechenden p-n-p-n-Struktur.

Da die schaltbaren Kurzschlüsse auf beiden Seiten des Bauelements angeordnet sind, kann der Halbleiterschalter unabhängig von der gerade gegebenen Stromrichtung abgeschaltet werden.

Weitere Ausführungsbeispiele ergeben sich aus den Unteransprüchen.

## KURZE BESCHREIBUNG DER ZEICHNUNG

Nachfolgend soll die Erfindung anhand von Ausführungsbeispielen im Zusammenhang mit der Zeichnung näher erläutert werden. Es zeigen

Fig.1 ein erstes Ausführungsbeispiel für ein Bauelement nach der Erfindung mit separaten Zündgates an den p-Basisschichten;

Fig.2 die J-U-Kennlinie eines Bauelements gemäss Fig.1 (und Fig.3);

Fig.3 eine zu Fig.1 alternative Ausführungsform des Bauelements mit vertikalen MOS-Gates;

Fig.4 ein weiteres Ausführungsbeispiel für ein Bauelement nach der Erfindung mit zusätzlichen IGBT-Zellen für die Zündung;

Fig.5 eine zu Fig.4 alternative Ausführungsform des Bauelements mit vertikalen MOS-Gates; und

Fig.6 die J-U-Kennlinie eines Bauelements gemäss Fig.4 (und Fig.5) mit Strombegrenzung.

## WEGE ZUR AUSFÜHRUNG DER ERFINDUNG

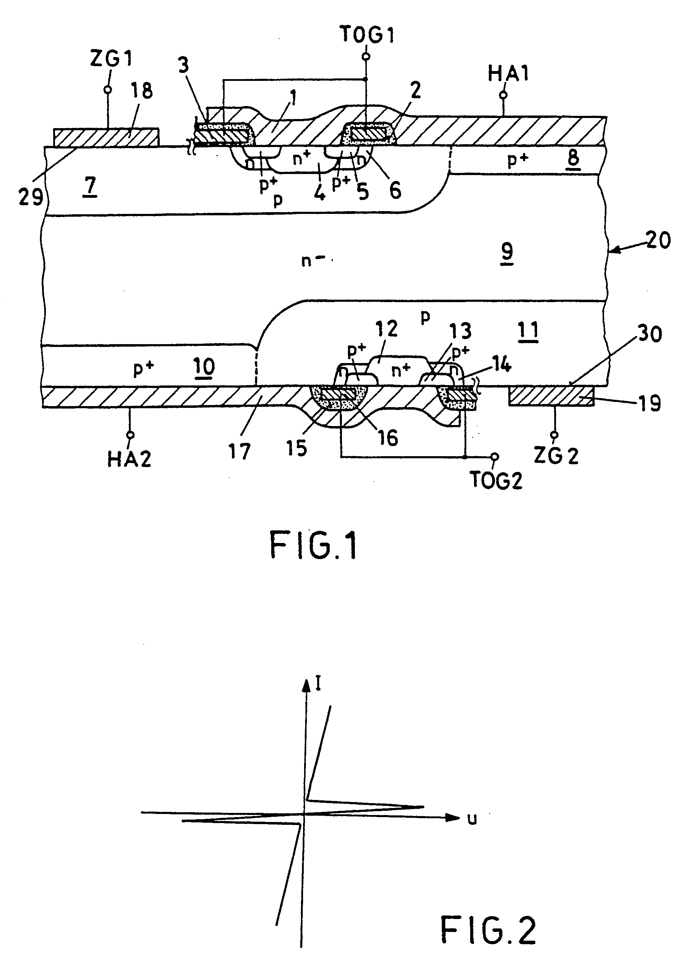

In der Fig.1 ist ein erstes Ausführungsbeispiel für ein Bauelement nach der Erfindung dargestellt.

Ein Halbleitersubstrat 20 (in der Regel aus Si) enthält zwischen zwei parallelen Hauptflächen 29 und 30 eine zen trale, $n^-$-dotierte n-Basisschicht 9, an die oben und unten jeweils eine p-dotierte p-Basisschicht 7 bzw. 11 angrenzen.

Die p-Basisschichten 7 und 11 sind lateral derart begrenzt, dass die n-Basisschicht 9 sich gegenüber der p-Basisschicht 11 zur ersten Hauptfläche 29 hin und gegenüber der p-Basisschicht 7 zur zweiten Hauptfläche hin erweitert. In den Bereichen der Erweiterung ist gegenüber der p-Basisschicht 11 eine $p^+$-dotierte p-Emitterschicht 8 und gegenüber der p-Basisschicht 7 eine $p^+$-dotierte p-Emitterschicht 10 von der jeweiligen Hauptfläche 29 bzw. 30 her in die n-Basisschicht 9 eingelassen.

In die p-Basisschicht 7 bzw. 11 ragen von der Oberfläche her $n^+$-dotierte n-Emittergebiete 4 bzw. 12 hinein, die mit MOS-gesteuerten Kurzschlüssen ausgestattet sind. Jeder dieser Kurzschlüsse umfasst ein $p^+$-dotiertes p-Sourcegebiet 5 bzw. 13, ein n-dotiertes n-Kanalgebiet 6 bzw. 14, die p-Basisschicht 7 bzw. 11 und isolierte Gateelektroden 3 bzw. 16.

Die n-Emittergebiete 4 bzw. 12 und die p-Emitterschichten 8 bzw. 10 werden von einer Hauptelektrode 1 bzw. 17 kontaktiert, die als Metallisierung (z.B. aus Al) auf die jeweilige Hauptfläche 29 bzw. 30 aufgebracht und von den darunterliegenden Gateelektroden 3 bzw. 16 durch Gateisolierungen 2 bzw. 15 elektrisch getrennt sind.

Zur Zündung sind neben den Hauptelektroden 1 bzw. 17 auf den Hauptflächen 29 bzw. 30 spezielle Gatemetallisierungen 18 bzw. 19 angeordnet, welche die darunterliegende p-Basisschicht 7 bzw. 11 direkt kontaktieren.

Jede Gatemetallisierung 18 bzw. 19 ist mit einem entsprechenden Zündgate ZG1 bzw. ZG2 verbunden, jede Gateelektrode 3 bzw. 16 mit einem entsprechenden Turn-Off-Gate TOG1 bzw. TOG2, und jede Hauptelektrode 1 bzw. 17 mit einem Hauptanschluss HA1 bzw. HA2.

Das Bauelement gemäss Fig.1 kann in beiden Richtungen durch die konventionellen Zündgates ZG1 bzw. ZG2 gezündet und durch Einschalten der MOS-gesteuerten Kurzschlüsse an den n-Emittergebieten 4 bzw. 12 abgeschaltet werden. Für den Strom J über der Spannung U eines solchen Bauelements ergibt sich dann eine Kennlinie gemäss Fig.2, die der Strom-Spannungs-Kennlinie eines herkömmlichen TRIACs entspricht.

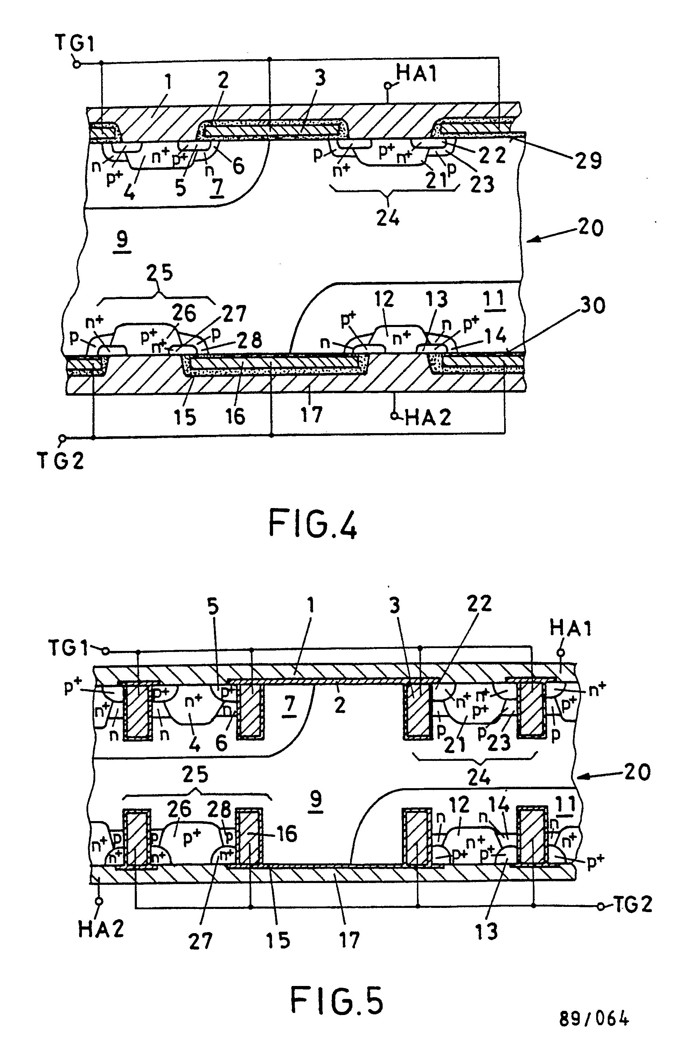

Eine zu Fig.1 alternative Ausführungsform eines konventionell gezündeten Bauelements nach der Erfindung ist in Fig.3 wiedergegeben. Hier werden für die MOS-gesteuerten Kurzschlüsse vertikale MOSFETs mit vertikal angeordneten Gateelektroden (meist aus Poly-Si) verwendet.

Derartige vertikale MOS-Strukturen bringen Vorteile bezüglich des Kanalwiderstandes (der leitenden p-Kanäle in den n-Kanalgebieten 6 bzw. 14) je Flächeneinheit. Je kleiner dieser Widerstand ist, um so höher liegen die maximal abschaltbaren Stromdichten. Darüberhinaus wird das Packaging eines solchen Bauelements erleichtert, weil beispielsweise die Hauptelektroden 1 und 17 vollständig planar ausgeführt werden können.

Eine andere bevorzugte Ausführungsform des Bauelements nach der Erfindung ist in Fig.4 dargestellt. Die n-Basisschicht 9, die p-Basisschichten 7 und 11, und die n-Emittergebiete 4 und 12 mit ihren MOS-gesteuerten Kurzschlüs sen sind hier vergleichbar angeordnet wie in dem Bauelement gemäss Fig.1.

Unterschiede ergeben sich in der Art der Zündung: Während die Zündung beim Bauelement der Fig.1 bzw. 3 konventionell über die üblichen Zündgates ZG1 und ZG2 erfolgt, sind beim Bauelement gemäss Fig.4 in den Bereichen, in denen sich die n-Basisschicht 9 erweitert und an die Oberfläche tritt, zum Zünden zusätzliche IGBT-Zellen 24 bzw. 25 vorgesehen, welche über dieselben Gateelektroden 3 bzw. 16 angesteuert werden wie die Kurzschlüsse der n-Emittergebiete 4 bzw. 12. Die Gateelektroden 3 bzw. 16 sind mit Turn-On/Off-Gates TG1 bzw. TG2 verbunden, die sowohl für das Ein- als auch für das Ausschalten des Bauelements zuständig sind.

Jede der IGBT-Zellen 24 bzw. 25 umfasst ein $p^+$-dotiertes, von der jeweiligen Hauptelektrode 1 bzw. 17 kontaktiertes p-Emittergebiet 21 bzw. 26 sowie MOS-gesteuerte Kurzschlüsse, die aus einem $n^+$-dotierten n-Sourcegebiet 22 bzw. 27, einem p-dotierten p-Kanalgebiet 23 bzw. 28, der n-Basisschicht 9 und den erweiterten Gateelektroden 3 bzw. 16 bestehen.

Durch die beidseitige Kombination von MCT- und IGBT-Zellen in einem Bauelement und deren Ansteuerung über ein MOS-Gate kann der Thyristor in beiden Richtungen sowohl ein- als auch ausgeschaltet werden:

Dazu wird angenommen, dass die Hauptelektrode 1 als Kathode auf Masse liegt. Die Hauptelektrode 2 besitze entsprechend als Anode ein positives Potential. Die Gate-Anoden-Spannung am zweiten Turn-On/Off-Gate TG2 betrage 0 V, so dass auf dieser (unteren) Seite des Bauelements keine Inversionskanäle (weder in den n-Kanalgebieten 14 noch in den p-Kanalgebieten 28) existieren. Gleiches soll zunächst auch für die andere (obere) Seite des Bauelements gelten. Weiterhin wird angenommen, dass der Thyristor in diesem Betriebsmodus sperrt.

Durch Anlegen einer positiven Gate-Kathoden-Spannung am ersten Turn-On/Off-Gate TG1 werden die n-Kanäle der ersten IGBT-Zellen 24 leitend und Elektronen gelangen in die n-Basisschicht 9. Hierauf beginnen die p-Emittergebiete 26 auf der (unteren) Anodenseite, Löcher in diese Gebiet zu emittieren. Der Thyristor wird auf diese Weise gezündet.

Das Abschalten kann auf mehrere Weisen vollzogen werden:

Bei einer Abschaltart kann am Gate der Kathodenseite (Turn-On/Off-Gate TG1) ein negatives Potential angelegt werden, so dass der p-Kanal in den n-Kanalgebieten 6 leitend und das n-Emittergebiet 4 damit kurzgeschlossen wird. Die IGBT-Zellen 24 auf der als Kathode definierten Seite sind bei diesem negativen Potential nicht aktiviert. Die Gebiete, in denen die n-Basisschicht 9 an die kathodenseitige Oberfläche des Halbleitersubstrats 20 stösst, befinden sich beim negativen Gatepotential im Zustand der Inversion. Die p-Emittergebiete 21 der IGBT-Zellen 24 und die p-Basisschicht 7 sind durch diese p-leitende Inversionsschicht leitend verbunden, so dass keine hohen Felder an der Grenzfläche Halbleitersubstrat 20/ Gateisolierung 2 vorhanden sind.

Bei einer zweiten Abschaltart kann der Thyristor durch Einschalten der anodenseitigen Kurzschlüsse (positives Potential des zweiten Turn-ON/Off-Gates TG2 gegenüber der Anode) ausgeschaltet werden.

Selbstverständlich können Anoden- und Kathodenkurzschlüsse auch gleichzeitig eingeschaltet werden. Ueber die dann aktivierten Kurzschlüsse fliessen Löcher aus der p-Basisschicht 7 und Elektronen aus der n-Basisschicht 9 solange ab, bis sich am Uebergang zwischen beiden Schichten eine Raumladungszone entwickelt. Sobald diese Zone hinreichend breit geworden ist, können Löcher, welche noch in der n-Basisschicht 9 verblieben sind, nur über den Mechanismus der Rekombination eliminiert werden. Dies ruft langsam abklingende "Tail"ströme hervor, die wesentlich zur Abschaltverlustleistung beitragen.

Zur Verringerung der Abschaltverluste ist es vorteilhaft, die Anodenkurzschlüsse (der p-Emittergebiete 26) kurzzeitig vor den Kathodenkurzschlüssen (der n-Emittergebiete 4) zu aktivieren. Während dieser kurzen Zeitspanne, welche im Bereich von einer bis zu wenigen $\mu$sec liegen sollte, ist die Löcherinjektion bereits unterbrochen, so dass die Löcherkonzentration in der n-Basisschicht 9 bereits zu sinken beginnt. Elektronen werden noch von der Kathode aus injiziert, so dass sich der ON-Widerstand noch nicht wesentlich ändert.

Ist die Löcherkonzentration in der n-Basisschicht hinreichend klein geworden, kann nun der Kathodenkurzschluss eingeschaltet werden. Wiederum können Löcher aus der p-Basisschicht 7 und Elektronen aus der n-Basisschicht 9 über die Kurzschlüsse abfliessen, bis sich am Uebergang zwischen diesen beiden Schichten die Raumladungszone ausbildet.

Der Vorteil gegenüber dem voerher diskutierten Fall besteht nun darin, dass die noch in der n-Basisschicht 9 verbleibende Löcherdichte erheblich kleiner ist. Dies wirkt sich in einer Verringerung der "Tail"ströme und damit der Abschaltverluste aus. Durch die Reduktion der Löcherdichte zum eigentlichen Abschaltzeitpunkt (gegeben durch das Einschalten der Kathodenkurzschlüsse) wird weiterhin der Einsatz des "dynamischen Avalanche" zu höheren Stromdichten hin verschoben.

Da das Bauelement gemäss Fig.4 symmetrisch aufgebaut ist, können die oben diskutierten Varianten für die Abschaltvorgänge unabhängig von der gerade vorliegenden Stromrichtung (Normal- oder Inversbetrieb) angewendet werden. Damit besitzt diese Bauelement ebenfalls die in Fig.2 dargestellte statische Kennlinie.

Ebenso wie man beim konventionell gezündeten Bauelement der Fig.1 durch die Verwendung von vertikalen MOS-Strukturen zum Bauelement der Fig.3 gelangt, kann zum Bauelement der Fig.4 mit kombinierten MCT- und IGBT-Zellen eine Alternative mit vertikalen MOS-Strukturen angegeben werden, die in Fig.5 dargestellt ist.

Abschliessend soll noch ein weiterer nützlicher Aspekt der Bauelemente gemäss Fig.4 und 5 erläutert werden:

Es sei hierzu angenommen, dass die Hauptelektrode 1 als Kathode an Masse liegt, Hauptelektrode 17 als Anode ein positives Potential besitzt und der Thyristor im Durchlass betrieben wird. Falls in dieser Situation ein Kurzschluss auftritt, welcher sich in einem Spannungsanstieg am Bauelement auswirkt, wird der Anodenstrom so weit ansteigen, bis das Bauelement thermisch zerstört wird.

Werden nun beim Ueberschreiten einer vorgegebenen maximalen Stromstärke (ein entsprechender Sensor kann in den Chip integriert werden) beide Gates an positives Potential gelegt, so entsteht folgende Situation: durch den Kurzschluss der Anode ist der Thyristor bestrebt, in den Sperrzustand überzugehen. Löcher- und Elektroneninjektion innerhalb der p-n-p-n-Struktur versiegen. Allerdings werden jetzt Elektronen aus den n-Sourcegebieten 22 der IGBT-Zellen 24 zu den eingeschalteten Anodenkurzschlüssen fliessen. Dieser unipolare Stromfluss entspricht dem Betrieb eines Leistungs-MOSFETs. Der bipolare Strom des Thyristors kann also als unipolarer Strom von den MOSFETs übernommen werden.

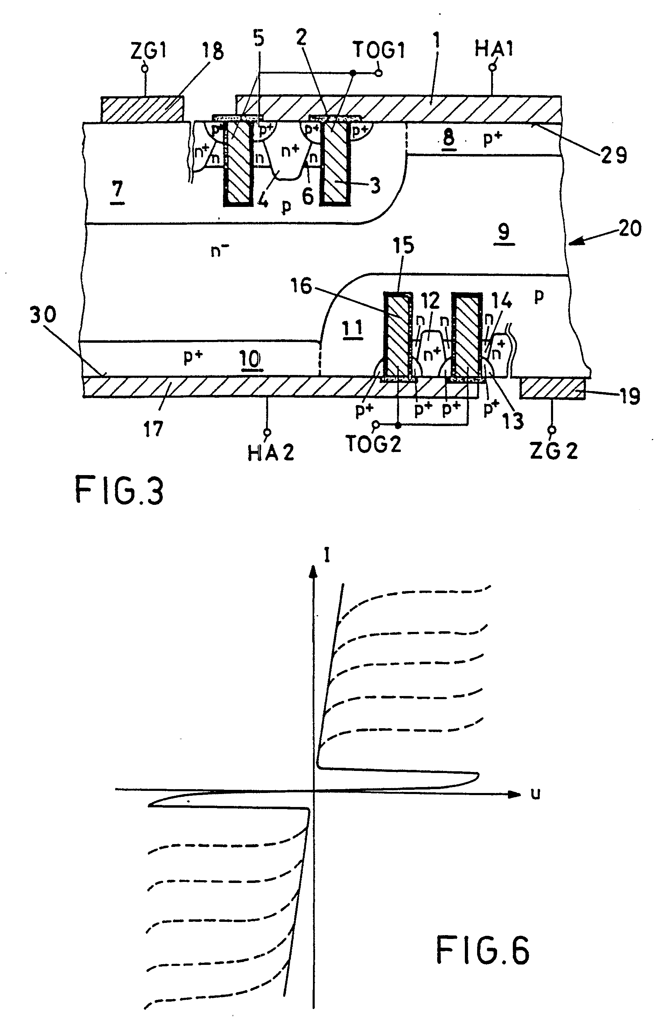

Da der MOSFET aber einen wesentlich grösseren ON-Widerstand besitzt, nimmt bei gleichem Strom (der Kurzschlussstrom soll ja begrenzt werden) die Spannung über dem Bauelement zu. Diese Strombegrenzung beim Betrieb des Bauelements als MOSFET im Sättigungsbereich ist erwünscht und kann das Bauelement vor der Zerstörung bewahren. Sie ist vom Gatepotential abhängig und in der statischen Kennlinie der Fig.6 als gestrichetes Kennlinienfeld eingezeichnet.

Für die Ansteuerung der Bauelemente gemäss Fig.4 und 5 lässt sich ingesamt folgende Tabelle aufstellen, die angibt, welcher Betriebszustand bei welchen Gatepotentialen (0 V, positiv oder negativ) vorliegt:

TABELLE

| Potential TG1 | Potential TG2 | Betriebszustand |
|:---:|:---:|:---|
| 0 | + | Turn-On invers |
| + | 0 | Turn-On normal |
| 0 | 0 | On-State |
| 0 | - | Turn-Off invers |
| - | 0 | Turn-Off normal |
| + | + | Saturate (IGBT-Mode) |

**Ansprüche**

1. Bidirektionales, abschaltbares Halbleiterbauelement, umfassend

(a) ein Halbleitersubstrat (20), welches durch zwei Hauptflächen (29, 30) begrenzt wird und zwischen den Hauptflächen (29, 30) eine Mehrzahl unterschiedlich dotierter Schichten aufweist;

(b) auf der ersten Hauptfläche (29) eine erste, zu einem ersten Hauptanschluss (HA1) gehörende Hauptelektrode (1);

(c) auf der zweiten Hauptfläche (30) eine zweite, zu einem zweiten Hauptanschluss (HA2) gehörende Hauptelektrode (17);

(d) im Inneren des Halbleitersubstrats (20) eine erste Basisschicht;

(e) unter der ersten Hauptelektrode (1) eine Anzahl von ersten Emittergebieten, welche von der ersten Hauptfläche (29) in das Halbleitersubstrat (20) hineinragen und von der ersten Hauptelektrode (1) kontaktiert werden;

(f) unter der zweiten Hauptelektrode (18) eine Anzahl von zweiten Emittergebieten, welche von der zweiten Hauptfläche (30) in das Halbleitersubstrat (20) hineinragen und von der zweiten Hauptelektrode (17) kontaktiert werden;

(g) erste, durch MOSFETs kontrollierte Kurzschlüsse, welche die ersten Emittergebiete kurzschliessen; und

(h) zweite, durch MOSFETs kontrollierte Kurzschlüsse, welche die zweiten Emittergebiete kurzschliessen;

dadurch gekennzeichnet, dass

(i) die ersten und zweiten Emittergebiete eine Dotierung mit derselben Polarität aufweisen wie die erste Basisschicht;

(k) zwischen der ersten Basisschicht und den ersten Emittergebieten eine mit entgegengesetzter Polarität dotierte zweite Basisschicht angeordnet ist, in welche die ersten Emittergebiete hineinragen;

(l) zwischen der ersten Basisschicht und den zweiten Emittergebieten eine mit entgegengesetzter Polarität dotierte dritte Basisschicht angeordnet ist, in welche die zweiten Emittergebiete hineinragen;

(m) die zweite und dritte Basisschicht lateral begrenzt ist, derart, dass die erste Basisschicht im Bereich der zweiten Basisschicht an die zweite Hauptfläche (30) und im Bereich der dritten Basisschicht an die erste Hauptfläche (29) tritt; und

(n) gegenüber der zweiten und dritten Basisschicht jeweils weitere Emitter zwischen der ersten Basisschicht und der zugehörigen Hauptelektrode (HA2 bzw. HA1) angeordnet sind, welche mit derselben Polarität dotiert sind wie die zweite und dritte Basisschicht.

2. Halbleiterbauelement nach Anspruch 1, dadurch gekennzeichnet, dass

(a) die erste Basisschicht eine n-dotierte n-Basisschicht (9) ist;

(b) die ersten und zweiten Emittergebiete jeweils $n^+$-dotierte n-Emittergebiete (4 bzw. 12) sind; und

(c) die zweite und dritte Basisschicht jeweils p-dotierte p-Basisschichten (7 bzw. 11) sind.

3. Halbleiterbauelement nach Anspruch 2, dadurch gekennzeichnet, dass die ersten und zweiten Kurzschlüsse jeweils ein $p^+$-dotiertes p-Sourcegebiet (5 bzw. 13), eine n-dotiertes n-Kanalgebiet (6 bzw. 14) die zugehörige p-Basisschicht (7 bzw. 11) und über dem n-Kanalgebiet (6 bzw. 14) angeordnete Gateelektroden (3 bzw. 16) umfassen.

4. Halbleiterbauelement nach Anspruch 3, dadurch gekennzeichnet, dass

6

(a) die weiteren Emitter $p^+$-dotierte p-Emitterschichten (8 bzw. 10) sind; und

(b) zur Zündung auf den Hauptflächen (29, 30) neben den Hauptelektroden (1, 17) jeweils zu einem Zündgate (ZG1, ZG2) gehörige Gatemetallisierungen (18, 19) angeordnet sind, welche direkt die entsprechende p-Basisschicht (7 bzw. 11) kontaktieren.

5. Halbleiterbauelement nach Anspruch 3, dadurch gekennzeichnet, dass

(a) die weiteren Emitter $p^+$-dotierte p-Emittergebiete (21 bzw. 26) sind; und

(b) zur Zündung bei den p-Emittergebieten (21 bzw. 26) durch MOSFETs kontrollierte Kurzschlüsse vorgesehen sind, welche jeweils ein $n^+$-dotiertes n-Sourcegebiet (22 bzw. 27), eine p-dotiertes p-Kanalgebiet (23 bzw. 28) sowie die n-Basisschicht (9) umfassen und durch die Gateelektroden (3 bzw. 16) angesteuert werden.

6. Halbleiterbauelement nach einem der Ansprüche 3 und 5, dadurch gekennzeichnet, dass die MOSFETs als vertikale MOSFETs ausgebildet sind, wobei die Gatelektroden (3 bzw. 16) vertikal in das Halbleitersubstrat (20) hineinragen.

FIG.1

FIG.2

FIG.4

FIG.5

89/064

FIG.3

FIG.6

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | EP-A-0 039 941 (SIEMENS AG) * Seite 6, Zeile 33 - Seite 7, Zeile 29; Seite 9, Zeile 16 - Seite 10, Zeile 2; Figuren 3,5 * | 1-4 | H 01 L 29/747 |
| A | EP-A-0 081 642 (GENERAL ELECTRIC CO.) * Seite 5, Zeile 10 - Seite 14, Zeile 6; Seite 23, Zeilen 21-28; Seite 24a, Zeile 18 - Seite 25, Zeile 7; Figuren 1,3 * | 1-6 | |
| A | PATENT ABSTRACTS OF JAPAN, Band 12, Nr. 498 (E-698)[3345], 26. Dezember 1988; & JP-A-63 209 172 (TOSHIBA CORP.) 30-08-1988 * Zusammenfassung; Figuren * | 1-3,5 | |
| A | US-A-4 199 774 (PLUMMER) * Spalte 7, Zeilen 17-50; Figuren 12-14 * | 1-3,5 | |
| | | | RECHERCHIERTE SACHGEBIETE (Int. Cl.5) |
| | | | H 01 L |

Der vorliegende Recherchenbericht wurde für alle Patentansprüche erstellt

| Recherchenort | Abschlußdatum der Recherche | Prüfer |
|---|---|---|
| DEN HAAG | 06-08-1990 | MORVAN D.L.D. |